# EUROPEAN PATENT SPECIFICATION

(11) **EP 1 979 951 B1**
(45) Date of publication and mention of the grant of the patent: **04.07.2012**
(21) Application number: 07701665.7
(22) Date of filing: 10.01.2007
(51) Int. Cl.: H01L 31/0376, H01L 31/0216, H01L 31/0224

(54) **SOLAR CELL**
SOLARZELLE
CELLULE SOLAIRE

(30) Priority: 26.01.2006 US 339851
(43) Date of publication of application: 15.10.2008
(73) Proprietor: Arise Technologies Corporation, Waterloo, Ontario N2V 1Y8 (CA)
(72) Inventor: KHERANI, Nazir Pyarali, Toronto, Ontario M9A 3W9 (CA); RAYAPROL, Bhanu Gangadhar, Etobicoke, Ontario M9R 1T4 (CA); YEGHIKYAN, Davit, Thornhill, Ontario, L3T 1B8 (CA); ZUKOTYNSKI, Stefan, Richmond Hill, Ontario L4C 6P8 (CA)
(74) Representative: Westwood, Joanna
(86) International application number: PCT/CA2007/000034
(87) International publication number: WO 2007/085072

(56) References cited:
- WO-A1-03/083955
- US-A- 4 927 720
- US-A- 5 030 295
- US-B1- 6 262 359
- US-B1- 6 387 726

## Description

### FIELD OF THE INVENTION

The present invention relates to thin film back-heterojunction, amorphous-crystalline silicon photovoltaic devices produced at low-temperatures.

### BACKGROUND OF THE INVENTION

Most of the present day silicon photovoltaic devices are configured so that a p-n junction is formed in silicon by diffusion of dopants at elevated temperatures and the application of electrodes on the light facing side and back-side. Back contacts on silicon photovoltaic devices are formed, using high temperature processing, to substantially overcome the shading losses on the light facing side. Amorphous-crystalline silicon heterojunction photovoltaic devices are formed by the deposition of amorphous silicon layers on crystalline silicon, thereby substantially providing for low temperature processing. In this case, the electrodes are applied on the light facing front side as well as back-side of the device.

JP 18413358 to Hamakawa et al., and United States Patent No. 4,496,788 disclose amorphous (microcrystalline) / crystalline semiconductor heterojunction solar cells. JP application S62-128572 to Nitta Kyocera disclose amorphous (or mc)-Si / a-Si (I) / crystalline Si heterojunction solar cells. JP 2740284 to Iwamoto et al. and United States Patent No. 5,066,340 disclose amorphous Si /(mc)-Si (I) / crystalline Si heterojunction solar cells. JP 2132527 to Noguchi et al. and United States Patent No. 5,213,628 disclose amorphous (P or N) / amorphous (I) / crystalline (N or P) heterojunction solar cells.

United States Patent No. 4,487,989 discloses a contact for a solar cell. United States Patent No. 5,641,362 discloses a structure and fabrication process for an aluminum alloy junction. United States Patent No. 4,927,770 is directed to a method of fabricating back surface point contact for solar cells.

There are several drawbacks to the prior art silicon photovoltaic devices, namely the front surface of the device that includes electrodes which block and absorb light, preventing it from reaching the underlying active silicon layer and thereby reducing the photogeneration of electron-hole pairs in the active silicon layer of the device. The presence of the electrical contacts on the front surface makes it problematic for applying an optimal antireflection layer on the front surface, since with the electrical contacts on the front surface they need to be both optically transmissive and electrically conductive. Further, since the contacts are in the path of the incident light, the electrical contacts and buses on the front surface cannot be significantly increased in size in order to further reduce the series resistance.

Prior art silicon photovoltaic devices that include contacts at the back, namely back contact photovoltaic devices, also exhibit several shortcomings. These devices are fabricated using high temperature processes such as thermal diffusion of dopants and growth of passivation and antireflection coatings. With the trend favouring the use of thin silicon wafers, these high temperature processes would lead to thermal damage. Also, use of high temperature processing increases the cost of processing and thus the cost of the device. In addition, these back contact photovoltaic devices invariably require high resolution photolithography and associated semiconductor processing.

Prior art silicon photovoltaic devices that use low temperature processing, namely amorphous-crystalline silicon heterojunction photovoltaic devices, also exhibit several shortcomings. The front surface of these devices includes electrodes which block and absorb light, reducing the light reaching the underlying active silicon layer and thereby reducing the photogeneration of carriers in the device. The presence of the electrical contacts on the front surface makes it problematic for applying an optimal antireflection layer on the front surface, since with the electrical contacts on the front surface they need to be both optically transmissive and electrically conductive. Further, since the contacts are in the path of the incident light, the electrical contacts and buses on the front surface cannot be significantly increased in size in order to further reduce the series resistance.

Therefore it would be very advantageous to fabricate a low temperature, thin film back-heterojunction, amorphous-crystalline silicon photovoltaic device in which the electrical contacts are delegated to the back surface. This eliminates shading losses, as well as permitting the application of an optimal antireflection layer on the front surface. Due to low temperature processing, this is amenable to the use of thinner wafers. Also, the device is amenable to the use of low resolution photolithography and simple shadow-masking methods. This novel device opens the way to future device developments in addition to addressing the above described shortcomings of the prior art.

WO 03/083955 to Mishima et al. discloses a solar cell having a silicon substrate **(11)** with an intrinsic semiconductor layer **(17)** on the back surface of the substrate **(11)** and back electrical contacts **(15)** and **(16)** located on the back surface of the layer **(12)** and a polyimide sealing layer **(17)** located on the on the layer **(12)** between the contacts **(15)** and **(16)**.

### SUMMARY OF THE INVENTION

The present invention describes a novel heterojunction solar cell having thin film amorphous silicon - crystalline silicon back heterojunction and back surface field device configuration prepared at low temperatures. In contrast to present day back junction devices, the back heterojunction device is fabricated by employing low cost processes. These include deposition of thin film layers at low temperature and deployment of low resolution mechanical/shadow masking/lithography. The low temperature of fabrication favours the use of thin silicon wafers. The configuration achieves separation of optimization requirements for efficient light absorption and carrier generation at the front and in the bulk, as well as charge carrier collection at the back.

The electrical contacts are positioned at the back surface thereby eliminating shadowing losses as these are not in the path of the incident light. Back contacts need to be optimized for maximum charge carrier collection without bothering about shading losses. A range of elements/alloys may be used to effect band-bending since both the heterojunction and surface field are at the back. All of the above features result in a very high efficiency solar cell. The open circuit voltage of the back heterojunction device is higher than that of an all-crystalline device.

Thus, in one aspect of the invention there is provided a solar cell, comprising:
a) a crystalline silicon wafer having a back surface and a front surface,;
b) a silicon containing transition-passivating layer, located on said back surface, and alternating n-doped (n-a-Si:H) regions and p-doped (p-a-Si:H) regions of hydrogenated amorphous silicon located on said silicon containing transition-passivating layer to form heterojunction structures; and
c) electrical contact electrodes and current buses located on the alternating n-doped regions and p-doped regions of hydrogenated amorphous silicon for collecting electrons and holes produced in said crystalline silicon wafer upon absorption of light therein, and wherein in operation, the solar cell is oriented so that light is incident on the front surface; said silicon-containing transition-passivating layer being made from a material selected from the group consisting of intrinsic hydrogenated amorphous silicon, ion implantation of a silicon containing material, doped hydrogenated amorphous silicon, silicon alloyed amorphous materials, hydrogenated silicon alloyed amorphous materials, micro/nano-crystalline silicon materials, and epitaxial silicon containing structures, and
including an electrically insulating reflective coating located on areas which include exposed areas of said silicon-containing transition-passivating layer located on said back surface for reflecting light which was not absorbed in its pass through a thickness of the crystalline silicon wafer to traverse back through the crystalline silicon wafer.

The light facing side of the silicon wafer may be textured for light trapping and it may often include anti-reflection coating(s) located on the textured surface for light trapping.

### BRIEF DESCRIPTION OF THE DRWAINGS

The invention will now be described, by way of non-limiting examples only, reference being made to the accompanying drawings, in which:
Figure 1 shows a cross sectional view of a configuration of a device constructed in accordance with the present invention;
Figure 2 shows cross sectional views of two configurations (A and B) of devices; and
Figure 3 shows a photovoltaic response measured in thin film back amorphous-crystalline heterojunction (BACH^{™}) silicon photovoltaic devices prepared using rudimentary methods of fabrication. (For structure definitions, see Figure 2).

### DETAILED DESCRIPTION OF THE INVENTION

The systems described herein are directed, in general, to embodiments of a solar cell. Although embodiments of the present invention are disclosed herein, the disclosed embodiments are merely exemplary and it should be understood that the invention relates to many alternatives forms. Furthermore, the Figures are not drawn to scale and some features may be exaggerated or minimized to show details of particular features while related elements may have been eliminated to prevent obscuring novel aspects. Therefore, specific structural and functional details disclosed herein are not to be interpreted as limiting but merely as a basis for the claims and as a representative basis for enabling someone skilled in the art to employ the present invention in a variety of manner. For purposes of instruction and not limitation, the illustrated embodiments are all directed to embodiments of solar cells.

As used herein, the term "about", when used in conjunction with ranges of dimensions such as thickness of layers of the solar cell or other physical properties or characteristics, such as temperatures of processing to produce the solar cells is meant to cover slight variations that may exist in the upper and lower limits of the ranges of dimensions or temperatures so as to not exclude embodiments where on average most of the dimensions are satisfied but where statistically dimensions may exist outside this region. It is not the intention to exclude embodiments such as these from the present invention.

The present invention provides a novel low-temperature, thin film back-heterojunction, amorphous-crystalline silicon photovoltaic device. The device disclosed herein is a departure and an improvement over the existing art of back-contact photovoltaic devices as well as heterojunction photovoltaic devices. The device disclosed herein uses low temperature thin film back-heterojunctions which are prepared by low temperature deposition of undoped and doped amorphous silicon on crystalline silicon, in contrast to the high temperature diffused back junctions in existing devices.

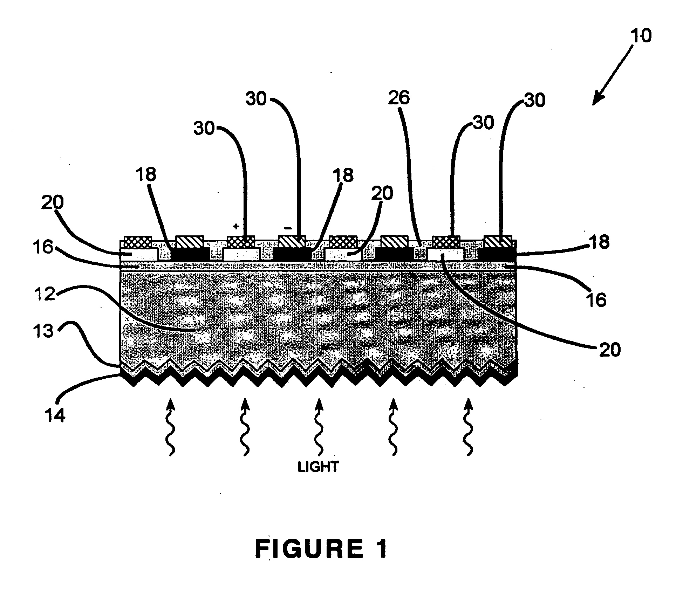

Referring first to Figure 1, a thin film back-heterojunction, amorphous-crystalline silicon photovoltaic device shown generally at 10 includes a crystalline silicon wafer 12 which may have a thickness in a range from about 100 µm to about 300 µm.

The front surface of the crystalline silicon wafer 12, which is often textured for light trapping, usually includes a passivating layer 13 and/or an antireflection coating 14 on top of passivating layer 13. The passivating layer 13 serves to minimize surface defect density and thus reduce recombination of carriers, while the anti-reflection coating 14 serves to enhance the light trapping. Anti-reflection layer 14 and/or passivation coating 13 may include thin film layers of silicon dioxide, silicon nitride, titanium dioxide, magnesium fluoride, hydrogenated amorphous silicon, and hydrogenated amorphous carbon. Low temperature passivation can be achieved, for example, with a thin film layer of plasma enhanced chemical vapour deposition (PECVD) of hydrogenated amorphous silicon or silicon dioxide deposited on the textured surface. In addition, passivation may be achieved through a variety of thermal and/or plasma treatments, as well as using a diversity of gas compositions, as well as a range of surface treatments well known to those skilled in the art. The thin film layer on the textured surface can consist of several sublayers/treatments.

The back surface of the crystalline silicon wafer 12 may include an intrinsic hydrogenated amorphous silicon (i-a-Si:H) transition layer 16 deposited with appropriate alternating n-doped (n-a-Si:H) regions 18 and p-doped (p-a-Si:H) regions 20 of hydrogenated amorphous silicon to create the back heterojunction structures. The total thickness of these layers 16 and 18/20 is kept as thin as practicable, typically of the order of a few angstroms to tens of nanometers.

Aluminum, silver or appropriate metal/alloy contacts 30 and current buses of optimized dimensions and composition are deposited on the doped regions on the back. A reflection layer 26 is deposited on the exposed areas of transition layer 16 and the n-and p-doped hydrogenated amorphous silicon regions 18 and 20 of the device to enable the light, which was not absorbed in the initial pass, to traverse back through the active crystalline silicon wafer 12 and thus be absorbed. The reflection layer 26 is electrically non-conducting.

Key aspects of the device include the low temperature formed heterojunction on the back surface complete with electrical contacts, while the front surface is optically transparent. The selective placement of the low temperature heterojunction on the back surface results in significant reduction of the junction area and hence leads to improved device performance. Further, the placement of the heterojunction on the back surface at low temperature is advantageous, as it permits the use of low -resolution lithography and/or shadow masking processes for producing the structures. There is no masking or shading of light on the front surface of the active crystalline silicon wafer 12, thereby permitting all light to impinge the device surface, unobstructed. The front surface is passivated with a passivating layer 13 to minimize surface defect density and thereby reducing the recombination of carriers. The front surface, being textured and having an anti-reflection coating, transmits essentially all impinging light. The anti-reflection coating 14 on the front surface of silicon wafer 12/13 is optimized only for reducing reflection losses, and is not required to be electrically conducting. Light is absorbed through the front surface of silicon wafer 12 through coatings 13 and 14 while electrical current is collected through the contacts 30 on the back surface of wafer 12. Reflection layer 26 incorporated on the back surface of silicon wafer 12 acts to back reflect the unabsorbed light and thus enhance the path length of the light, resulting in increased light absorption. Having electrical junctions and contacts on one side of the device increases the packing density of the devices and facilitates flexibility in achieving series and parallel connections.

There are several significant advantages achieved with the device disclosed herein, namely the formation of junctions on the back surface at low temperature, thereby allowing the use of low resolution lithography and/or shadow masking processes, and minimization of the heterojunction area of the device. Also, the configuration allows device fabrication through the use of thin silicon wafers. Further, the front surface of the device is free of electrodes and junctions, in contrast to the shading and light absorption by contacts in existing amorphous-crystalline silicon heterojunction devices. The delegation of electrical contacts to the back surface eliminates shading losses and permits the application of an optimal antireflection layer on the front surface, as opposed to the requirement of an antireflection layer which needs to be both optically transmissive and electrically conductive. Further, the electrical contacts and buses on the back can be optimized only for minimal series resistance, and do not require any consideration for shading since the contacts are not in the path of the incident light. Furthermore, the use of the amorphous-crystalline heterojunction (18/20-16-12) results in a higher open circuit voltage of the device when compared with an all-crystalline device.

The device may be fabricated in many ways familiar to those skilled in the art. Using a non-limiting and illustrative method, the device can be fabricated by starting with the crystalline silicon substrate, and all or essentially all device fabrication steps can be carried out by low temperature (below ~200°C) methods of processing. These processing steps prevent thermal damage to the thin substrates used as well as reduce the thermal budget. Device fabrication essentially involves the deposition of thin films for junction formation, contacts, back reflection, antireflection and passivation. Interfacial passivation is achieved by a variety of means which can include deposition of intrinsic or lightly doped hydrogenated amorphous silicon, PECVD or equivalently grown epitaxial silicon, and thermal and plasma treatments under various process parameters. The device fabrication is carried out with simple cost effective shadow/mechanical masking and/or low resolution photolithographic methods. For example, one simple shadow masking approach would be to use a patterned polished crystalline wafer mask on a polished back surface of the crystalline wafer 12. The front surface which has no electrodes located on it, is textured as well as covered with the aforementioned passivation layer 13 and anti-reflection coating 14. The thin n-and p-type layers (18, 20) and the electrodes 30 for carrier collection are deposited on the back. The back surface is coated with the reflection layer 26.

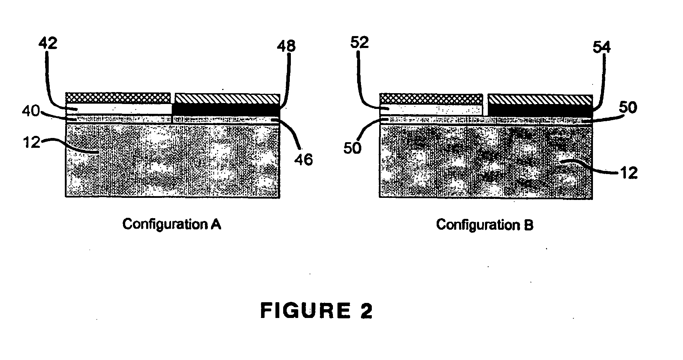

Devices made according to the present invention clearly demonstrated a photovoltaic effect in thin film back-heterojunction amorphous-crystalline silicon photovoltaic devices. The structures of two such devices are shown in Figure 2. These structures were made using rudimentary fabrication processes, including all masking and alignment steps.

Configuration A includes a crystalline silicon wafer 12 with the back surface electrode structure produced by first masking one half of the back surface and then depositing an intrinsic hydrogenated amorphous silicon layer 40 and an n-doped hydrogenated amorphous silicon layer 42 is deposited on top of the intrinsic layer 40. The side with layers 40 and 42 located thereon is then masked and then an intrinsic hydrogenated amorphous silicon layer 46 is deposited on silicon wafer 12 and a p-doped hydrogenated amorphous silicon layer 48 on top of the intrinsic layer 46. With a mask along the centre overlapping the inner edges of layers 42 and 46, aluminum electrodes are evaporated on the n-and p-doped silicon layers.

Configuration B includes a crystalline silicon wafer 12 with the back surface electrode structure produced by first depositing an intrinsic hydrogenated amorphous silicon layer 50 on the entire back surface of silicon wafer 12. One side was then masked and an n-doped hydrogenated amorphous silicon layer 52 is deposited on top of the unmasked half of the intrinsic layer 50. The n-doped hydrogenated amorphous silicon layer 52 is then masked and a p-doped hydrogenated amorphous silicon layer 54 deposited on top of the other half of the back surface of the intrinsic layer 50. With a mask along the centre overlapping the inner edges of layers 52 and 54, aluminum electrodes are evaporated on the n-and p-doped silicon layers.

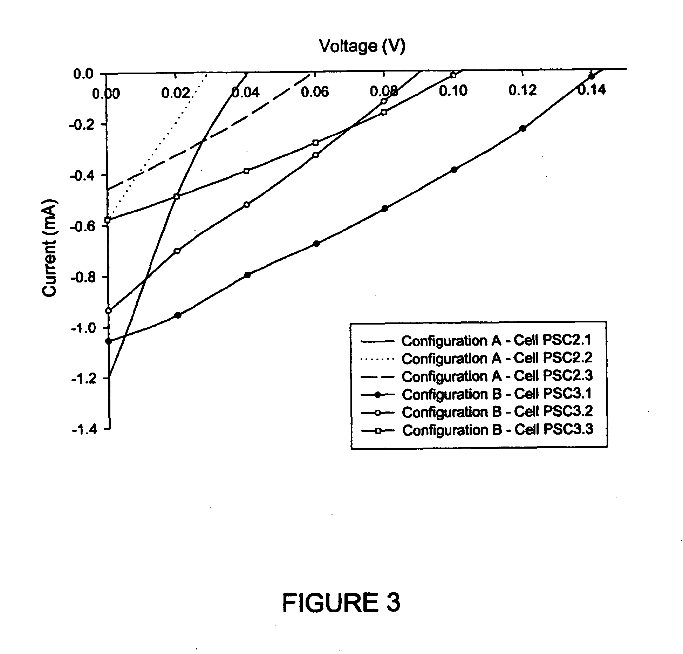

The photovoltaic response of the devices for the two configurations is shown in Figure 3. These results show that devices produced in accordance with the present invention clearly lead to a good photovoltaic effect.

It will be understood by those skilled in the art that while the photoactive element 12 in which the carriers are photogenerated has been described with respect to silicon wafers, the photoactive element may also be a thin silicon solar cell. As a specific case, thin silicon on glass and other substrates, where the silicon is of the order of tens of microns thick and therefore not a "wafer" in the conventional case, can also be subjected to the low temperature back heterojunction configuration as disclosed herein and hence the term "wafer" is also meant to cover embodiments using these thinner films as well.

Novel features of the devices produced in accordance with the present invention can be summarized as the confluence of a change from homojunction to heterojunction, front and back electrical contacts to back contacts, high temperature to low temperature processing or fabrication conditions, high resolution lithography to low resolution masking techniques, and a step favourable for the use of thin wafers.

As used herein, the terms "comprises", "comprising", "including" and "includes" are to be construed as being inclusive and open ended, and not exclusive. Specifically, when used in this specification including claims, the terms "comprises", "comprising", "including" and "includes" and variations thereof mean the specified features, steps, processes or components are included. These terms are not to be interpreted to exclude the presence of other features, steps or components.

The foregoing description of the preferred embodiments of the invention has been presented to illustrate the principles of the invention and not to limit the invention to the particular embodiment illustrated. It is intended that the scope of the invention be defined by all of the embodiments encompassed within the following claims and their equivalents.

## Claims

1. A solar cell **(10)**, comprising:
a) a crystalline silicon wafer **(12)** having a back surface and a front surface;
b) a silicon-containing transition-passivating layer **(16),** located on said back surface, and alternating n-doped (n-a-Si:H) regions **(18)** and p-doped (pa-Si:H) regions **(20)** of hydrogenated amorphous silicon located on said silicon-containing transition-passivating layer **(16)** to form heterojunction structures;
c) electrical contact electrodes and current buses **(30)** located on the alternating n-doped (n-a-Si:H) regions **(18)** and p-doped (p-a-Si:H) regions**(20)** of hydrogenated amorphous silicon for collecting electrons and holes produced in said crystalline silicon wafer **(12)** upon absorption of light therein, and wherein in operation the solar cell **(10)** is oriented so that light is incident on said front surface, the solar cell **(10) characterized in that**;
d) said silicon-containing transition-passivating layer **(16)** being made from a material selected from the group consisting of intrinsic hydrogenated amorphous silicon, ion implantation of a silicon containing material, doped hydrogenated amorphous silicon, silicon alloyed amorphous materials, hydrogenated silicon alloyed amorphous materials, micro/nano-crystalline silicon materials, and epitaxial silicon containing structures, and
including an electrically insulating reflective coating **(26)** located on areas which include exposed areas of said silicon-containing transition-passivating layer **(16)** located on said back surface for reflecting light which was not absorbed in its pass through a thickness of the crystalline silicon wafer **(12)**, to traverse back through the crystalline silicon wafer **(12)**.

2. The solar cell **(10)** according to claim 1 including a passivating layer (13) located on said front surface.

3. The solar cell **(10)** according to claim 2 including an antireflection coating **(14)** located on said passivating layer **(13)**.

4. The solar cell **(10)** according to claim 1 including an antireflection coating **(14)** located on said front surface.

5. The solar cell **(10)** according to claims 3 or 4 wherein said antireflection coating **(14)** is made from a material selected from the group consisting of PECVD silicon dioxide, titanium dioxide, magnesium fluoride, hydrogenated amorphous silicon, hydrogenated amorphous carbon, silicon nitride and intrinsic hydrogenated amorphous silicon.

6. The solar cell **(10)** according to claim 1, 2, 3, 4 or 5 wherein said front surface is textured to give the front surface a morphology which traps light reflected from said front surface.

7. The solar cell **(10)** according to claims 1, 2, 3, 4, 5 or 6 wherein said electrical contact electrodes and current buses **(30)** are made from a metal selected from the group consisting of aluminum, silver and copper.

8. The solar cell **(10)** according to claims 1, 2, 3, 4, 5, 6, or 7 wherein a combined thickness of said silicon-containing transition-passivating layer **(16)** and said alternating n-doped (n-a-Si:H) regions **(18)** and p-doped (p-a-Si:H) regions **(20)** of hydrogenated amorphous silicon is in a range from a few angstroms to tens of nanometers.

9. The solar cell **(10)** according to any one of claims 1 to 8 wherein said silicon wafer is a thin silicon layer having a thickness of at least about one micron.

10. The solar cell **(10)** according to any one of claims 1 to 9 wherein said silicon wafer is integrated with elements for light trapping and electrical contacts for current extraction.

11. The solar cell **(10)** according to any one of claims 1 to 10 used for radiovoltaic or electron-voltaic energy conversion devices.

12. The solar cell **(10)** according to any one of claims 1 to 11 wherein said silicon-containing transition-passivating layer **(16)** located on said back surface is a continuous layer.

## Patentansprüche

1. Solarzelle (10) mit:
a) einem Wafer (12) aus kristallinem Silizium mit einer Rück- und einer Vorderseite;
b) einer Silizium enthaltenden übergangspassivierenden Schicht (16) auf der Rückseite sowie abwechselnden n-dotierten (n-a-Si:H) Bereichen (18) und p-dotierten (p-a-Si:H) Bereichen (20) aus hydriertem amorphem Silizium auf der siliziumhaltigen übergangspassivierenden Schicht (16) zur Bildung von Heteroübergangs-Strukturen;
c) elektrischen Kontaktelektroden und Strom-Sammelleitungen (30) auf den abwechselnd n-dotierten (n-a-Si:H) Bereichen (18) und p-dotierten (p-a-Si:H) Bereichen (20) aus hydrierten amorphen Silizium zum Auffangen von Elektronen und Löchern, die im kristallinen Silizium-Wafer (12) bei der Lichtabsorption in ihm entstehen, wobei im Betrieb die Solarzelle (10) so orientiert ist, dass Licht auf die Vorderfläche fällt;
**dadurch gekennzeichnet, dass**
d) die siliziumhaltige übergangspassivierende Schicht (16) aus einem Stoff hergestellt ist, der gewählt ist aus der Gruppe bestehend aus intrinsischem hydriertem amorphem Silizium, Ionen-Implantation von einem Silizium enthaltenden Material, dotierten hydrierten amorphen Silizium, mit Silizium legierten Materialien, hydrierten siliziumlegierten amorphen Stoffen, mikro/nanokristallinen Siliziummaterialien und epitaxialen siliziumhaltigen Strukturen; und
ein elektrisch isolierender reflektierender Belag (26) eingeschlossen ist, der auf Bereichen angeordnet ist, die freiliegende Flächen der siliziumhaltigen übergangspassivierenden Schicht (16) auf der Rückseite beinhalten, um beim Durchgang durch eine Dicke des kristallinen Siliziumwafers (12) nicht absorbiertes Licht zu reflektieren, so dass es den kristallinen Siliziumwafer (12) zurück durchläuft.

2. Solarzelle (10) nach Anspruch 1 mit einer Passivierungsschicht (13) auf der Vorderseite.

3. Solarzelle (10) nach Anspruch 2 mit einer Antireflex-Beschichtung (14) auf der Passivierungsschicht (13).

4. Solarzelle (10) nach Anspruch 1 mit einer Antireflex-Beschichtung (14) auf der Vorderseite.

5. Solarzelle (10) nach Anspruch 3 oder 4, deren Antireflex-Beschichtung (14) aus einem Stoff gebildet ist, der gewählt ist aus der Gruppe bestehend aus PECVD-Siliziumdioxid, Titandioxid, Magnesiumfluorid, hydriertem amorphem Silizium, hydriertem amorphem Kohlenstoff, Siliziumnitrid und intrinsischem hydriertem amorphem Silizium.

6. Solarzelle (10) nach Anspruch 1, 2, 3, 4, oder 5, deren Vorderseite texturiert ist, um ihr eine Morphologie zu erteilen, die von der Vorderseite reflektiertes Licht auffängt.

7. Solarzelle (10) nach Anspruch 1, 2, 3, 4, 5 oder 6, deren elektrische Kontaktelektroden und Strom-Sammelleitungen (30) aus einem Metall aus der Gruppe Aluminium, Silber und Kupfer ausgebildet sind.

8. Solarzelle (10) nach Anspruch 1, 2, 3, 4, 5, 6 oder 7, bei der die Summendicke der siliziumhaltigen übergangspassivierenden Schicht (16) und der abwechselnden n-dotierten (n-a-Si:H) und p-dotierten (p-a-Si:H) Bereiche (18 bzw. 20) aus hydriertem amorphem Silizium im Bereich von einigen Ångstrom bis mehreren zehn Nanometern liegt.

9. Solarzelle (10) nach einem der Ansprüche 1 bis 8, bei der der Siliziumwafer eine dünne Siliziumschicht einer Dicke von mindestens etwa 1 Mikron ist.

10. Solarzelle (10) nach einem der Ansprüche 1 bis 9, bei der der Siliziumwafer mit Elementen für das Auffangen von Licht und elektrischen Kontakten für die Stromabfuhr integriert ist.

11. Solarzelle (10) nach einem der Ansprüche 1 bis 10 in der Verwendung für radio- oder elektronenvoltaische Energiewandlereinrichtungen.

12. Solarzelle (10) nach einem der Ansprüche 1 bis 11, bei der die siliziumhaltige übergangspassivierende Schicht (16) auf der Rückseite eine durchgehende Schicht ist.

## Revendications

1. Cellule solaire (10) comprenant :
a) une galette de silicium cristallin (12) ayant une face arrière et une face avant ;
b) une couche passivante de transition contenant du silicium (16), disposée sur ladite face arrière, et des régions dopées n (n-a-Si:H) (18) et des régions dopées p (p-a-Si:H) (20) alternées de silicium amorphe hydrogéné situées sur ladite couche passivante de transition contenant du silicium (16) pour former des structures à hétérojonction ;
c) des électrodes à contact électrique et des bus de courant (30) disposés sur les régions dopées n (n-a-Si:H) (18) et les régions dopées p (p-a-Si:H) (20) alternées de silicium amorphe hydrogéné pour collecter les électrons et trous produits dans ladite galette de silicium cristallin (12) lors de l'absorption de la lumière qui y pénètre, et dans laquelle en fonctionnement la cellule solaire (10) est orientée de façon que la lumière soit incidente sur ladite face avant, la cellule solaire (10) étant **caractérisée en ce que** :
d) ladite couche passivante de transition contenant du silicium (16) est réalisée à partir d'un matériau sélectionné parmi le groupe composé du silicium amorphe hydrogéné intrinsèque, de l'implantation d'ions dans un matériau contenant du silicium, du silicium amorphe hydrogéné dopé, des matériaux amorphes alliés au silicium, des matériaux amorphes alliés au silicium hydrogéné, des matériaux de silicium micro/nano-cristallins et des structures contenant du silicium épitaxial, et
incluant un revêtement réfléchissant électriquement isolant (26) situé sur les zones qui incluent les zones exposées de ladite couche passivante de transition contenant du silicium (16) située sur ladite face arrière pour refléter la lumière qui n'a pas été absorbée lors de son passage au travers d'une épaisseur de la galette de silicium cristallin (12), pour traverser en retour la galette de silicium cristallin (12).

2. Cellule solaire (10) selon la revendication 1 incluant une couche passivante (13) disposée sur ladite face avant.

3. Cellule solaire (10) selon la revendication 2 incluant un revêtement antiréfléchissant (14) situé sur ladite couche passivante (13).

4. Cellule solaire (10) selon la revendication 1 incluant un revêtement antiréfléchissant (14) situé sur ladite face avant.

5. Cellule solaire (10) selon les revendications 3 ou 4 dans laquelle ledit revêtement antiréfléchissant (14) est réalisé à partir d'un matériau sélectionné dans le groupe consistant en le dioxyde de silicium PECVD, le dioxyde de titane, le fluorure de magnésium, le silicium amorphe hydrogéné, le carbone amorphe hydrogéné, le nitrure de silicium et le silicium amorphe hydrogéné intrinsèque.

6. Cellule solaire (10) selon les revendications 1, 2, 3, 4 ou 5 dans laquelle ladite face avant est texturée pour donner à la face avant une morphologie qui piège la lumière réfléchie depuis ladite face avant.

7. Cellule solaire (10) selon les revendications 1, 2, 3, 4, 5 ou 6 dans laquelle lesdites électrodes à contact électrique et bus de courant (30) sont réalisés à partir d'un métal sélectionné parmi le groupe composé de l'aluminium, de l'argent et du cuivre.

8. Cellule solaire (10) selon les revendications 1, 2, 3, 4, 5, 6 ou 7 dans laquelle une épaisseur combinée de ladite couche passivante de transition contenant du silicium (16) et lesdites régions dopées n (n-a-Si:H) (18) et régions dopées p (p-a-Si:H) (20) alternées de silicium amorphe hydrogéné se situent dans une plage de quelques angströms à quelques dizaines de nanomètres.

9. Cellule solaire (10) selon l'une quelconque des revendications 1 à 8 dans laquelle ladite galette de silicium est une galette de silicium mince ayant une épaisseur d'au moins environ un micron.

10. Cellule solaire (10) selon l'une quelconque des revendications 1 à 9 dans laquelle ladite galette de silicium est intégrée avec des éléments de piégeage de la lumière et des contacts électriques pour l'extraction du courant.

11. Cellule solaire (10) selon l'une quelconque des revendications 1 à 10 utilisée pour des dispositifs de conversion d'énergie radiovoltaïque ou électron-voltaïque.

12. Cellule solaire (10) selon l'une quelconque des revendications 1 à 11 dans laquelle ladite couche passivante de transition contenant du silicium (16) située sur ladite face arrière est une couche continue.
